# EUROPEAN PATENT SPECIFICATION

(11) **EP 0 497 617 B1**
(45) Date of publication and mention of the grant of the patent: **24.04.1996**
(21) Application number: 92300846.0
(22) Date of filing: 31.01.1992
(51) Int. Cl.: G01R 31/36, H01M 10/48

(54) **Battery voltage tester**
Batteriespannungstester
Testeur de tension de pile

(30) Priority: 31.01.1991 US 648069
(43) Date of publication of application: 05.08.1992
(73) Proprietor: EVEREADY BATTERY COMPANY, INC., St. Louis Missouri 63164 (US)
(72) Inventor: Huhndorff, Harry R., Bay Village, OH 44140 (US)
(74) Representative: Lord, Hilton David

(56) References cited:
- EP-A- 0 450 938
- EP-A- 0 523 901
- US-A- 4 723 656
- US-A- 5 015 544

## Description

The present invention relates to an electrochemical cell and a state-of-charge tester therefor, the cell comprising an open-ended container for the active ingredients of the cell and providing one terminal, a cover providing the other terminal of the cell and being sealed over and insulated from the open end of the container, the tester being resiliently deformable and configured so that, when in use, it can be caused to contact both terminals of the battery to complete a circuit therebetween, the tester further comprising an electrically resistive portion between the terminal contacts and in cooperative contact with an element visibly responsive to the condition of the resistive portion.

Several devices have been developed for testing dry cell batteries to determine the freshness or state of charge of the cell. For example, US-A-4,723,656 discloses a blister-type package for new batteries, a battery condition indicator being built into the blister portion of the package. The blister can then be deformed to place the tester across the terminals of the battery to be tested.

The tester disclosed above employs a thermochromic material in combination with a shaped resistive element. The flow of current causes a relative temperature gradient to be generated across the resistive element, thereby causing a colour change in the thermochromic material and indicating the state of charge of the battery.

The problem with this form of tester is that, as described, the tester is associated with the package in which the batteries are purchased. Once the batteries are removed from the package, the package will usually be discarded, preventing further testing of the cells by that tester.

Several patents have been issued to Robert Parker, for example US-A-4,702,563; US-A-4,702,564; US-A-4,726,661 and US-A-4,737,020 all, of which essentially disclose a independent, flexible battery tester having a conductive circuit pattern associated with a layer of thermochromic material. The flexible member is bent so that the circuit pattern can contact the positive and negative terminals of the battery to be tested and, again, the temperature gradient is reflected in the thermochromic material, thereby indicating the state of charge of the battery.

EP-A-0 450 938, published after the priority of this application discloses battery testers, which are well known devices, but these devices ten to be bulky and inconvenient to use. Furthermore, known devices do not allow ease of operation for all types of battery cells. Described herein is a voltmeter arrangement which can be used as an improved battery tester. The voltmeter comprises a dielectric layer, a conductive layer positioned adjacent the dielectric layer, and a temperature sensitive color indicator layer in contact with the conductive layer. The conductive layer is capable of generating sufficient heat to effect a change in the temperature sensitive control indicator layer. The voltmeter can be integrated with a label and attached directly to a battery.

All of the above testers suffer from the same deficiency, in that the tester is an element separate from the cell which, in the case of the package, is usually thrown away and, in the case of the Parker patents, can be lost or misplaced. In either case, the state of charge of the battery is indeterminable, once the testing device is no longer available.

In a first aspect, the present invention provides an electrochemical cell and a state-of-charge tester therefor, the cell comprising an open-ended container for the active ingredients of the cell and providing one terminal, a cover providing the other terminal of the cell and being sealed over and insulated from the open end of the container, the tester being resiliently deformable and configured so that at least one of the terminal contacts is biassed away from contact with the relevant terminal such that manual pressure is sufficient to complete the contact thereby to complete a circuit between both terminals of the battery, the tester further comprising an electrically resistive portion between the terminal contacts and in cooperative contact with an element visibly responsive to the condition of the resistive portion, characterised in that the tester is located on an end of the cell, the terminal contacts of the tester are secured in proximity to the cover, and wherein said manual pressure is exertable at said end of the cell and at the periphery of the cover.

The tester is preferably adapted so that the terminal contacts make contact with the cover and the container in close proximity to the insulating seal therebetween. In a standard cell, where the cover provides the bottom of the cell, the seal is located about the periphery of the bottom of the cell.

It is preferable that the contacts are spaced across the periphery of the cover, but they may be spaced across the seal, if this is located in a different position. In a preferred embodiment, the contacts are adjacent each other across the seal, and manual pressure over the two can establish the necessary contact.

It will be appreciated that one or both of the contacts can be biassed away from its terminal. Where the two contacts are close together, pressure from one digit may be sufficient to bring both contacts into contact with their terminals, where both contacts are biassed.

If the contacts are spaced apart and both are biassed, then it may be necessary to apply two digits to effect contact. This may be advantageous for cells where pressure is normally exerted on the bottom, such as by a leaf spring in the device.

The term "normal' is used to indicate that the tester is located on a portion of the cell which is not a major wall of the container, and is generally the bottom. The bottom of a cell may not necessarily be at 90° to the container, in which case it is unlikely that the tester will be at 90°. Such an embodiment is envisaged by the invention.

The resistive portion is advantageously as long as possible, so as to provide maximum visible exposure. While it is possible that the resistive portion is not secured to the cell, such an embodiment would likely be fragile. Accordingly, it is preferred that the resistive portion is affixed to the cell. In addition, it is preferred that the resistive portion is located about the periphery of the bottom, so that it may readily be observed by a user pressing the contact(s).

The responsive element may be anything that responds to the state of the resistive element. Such an element will usually comprise a thermochromic or electrochromic material. Such materials need to be in close enough contact with the resistive element to respond to its condition. In the case of the thermochromic material, this requires that heat generated by the resistive portion can affect the thermochromic material while, in the case of the electrochromic material, a DC potential must be able to act on the indicator.

Advantageously, the tester is in the form of a washer situated on the bottom of the cell, with a suitable substrate supporting the various elements of the tester. This washer is advantageously held on the cell by a shrink-wrap label, such as is usually found on cells of this type. Alternatively, the tester may be held on by adhesive, for example.

To provide bias, the tester may be of a resilient material, with a spacer located immediately adjacent the contact, so that pressure may effect temporary contact while applied. Alternatively, the washer, where employed, may be of a resilient material deformable to permit contact of the ends of the tester with their terminals. Other embodiments will be apparent to those skilled in the art.

The tester may be detachable, if so desired. In use, the tester should not obstruct contact of the cell with the device to be powered. However, the tester may comprise a safety cover to prevent inadvertant electrical contact with the bottom of the cell prior to use, for example.

The present invention also provides a combination of an integral battery and state-of-charge indicating device comprising:
a battery having a first and a second external terminal of opposite polarity;
a state-of-charge indicating device comprising:
a flexible member on the battery covering a portion of each of the first and second terminals;
an indicating material on one surface of the flexible member; and
conductive means on the flexible member in association with the indicating material and positioned for electrical contact with the first and second external terminals, whereby pressure on the flexible member will cause the conductive means to complete an electrical circuit between the first and second external terminals on the battery causing the indicating material to change optical absorption to an extent depending on the state of charge of the battery.

In the combination, the indicating material is preferably a thermochromic material; and
the conductive means is a shaped conductive pattern in thermal contact with the indicating material.

The indicating material is preferably a liquid crystal material.

The combination preferably has an indicating material which is an electrochromic material and which undergoes a colour change or change in optical absorption as part of an oxidation/reduction reaction caused by the direct application of a DC electrical potential to the material, and the conductive means are spaced electrical contacts for contacting the first and second external terminals on the battery and for directly applying the DC potential from the battery to the electrochromic material.

The combination preferably comprises spaced discrete areas of indicating material, the number of the areas which change colour indicating the state of charge of the battery.

The indicating material is advantageously a combination of layers of thermochromic materials that are activated at different temperatures.

Preferably the flexible member is a washer-like member of substantially the same peripheral dimensions as the battery and the indicating material and conductive means are on the same side of the washer-like member.

The combination preferably includes an electrical insulating coating on the conductive means except in the area where the conductive means is positioned for electrical contact with the first and second external terminals on the battery.

It is preferred that the first terminal of the battery is an end cover for the battery, and the second terminal is in contact with the housing for the battery; the flexible member has a first end for contacting the first terminal of the battery and a second terminal for contacting the second terminal of the battery, and the flexible member is disposed on the end cover of the battery.

In a further aspect of the present invention, there is provided a battery having an integral state-of-charge indicating device comprising:
a conductive housing containing the active components of the battery;
a first conductive cover member attached to one end of the housing, the first conductive cover member being electrically connected to the housing and forming the positive terminal for the battery;
a second conductive cover member for closing the opposite end of the housing, the second conductive cover member being electrically insulated from the housing, the second conductive cover member forming the negative terminal for the battery;
a state-of-charge indicating device disposed on the second conductive cover member, the indicating device comprising:
a flexible member shaped to conform to the housing;
a layer of thermochromic material on one surface of the member;
a shaped conductive pattern on the surface of the thermochromic material, the conductive pattern having first and second end portions;
a layer of electrical insulating material on the conductive pattern, the insulating material having an opening so as to leave exposed at least one of the first and second end portions of the conductive pattern so that when pressure is applied to the surface of the flexible member above the first and second end portions of the conductive pattern one of the end portions will contact the positive terminal while the other end portion contacts the negative terminal causing the conductive pattern to heat and change the colour of the thermochromic material thereby indicating the state of charge of the battery.

The battery preferably has a label covering the surface of the housing with the ends of the label rolled over the edge of the first and second conductive covers, the state-of-charge indicating device being held in contact with the second conductive cover by the rolled edge of the label.

In a yet further aspect, there is provided a battery having an integral state-of-charge indicating device comprising:
a housing containing the active components of the battery;
a first conductive member on the housing forming a first external terminal for the battery;
a second conductive member on the housing forming a second external terminal for the battery;
a state-of-charge indicating device disposed on the housing adjacent the first and second conductive members, the device comprising:
a flexible member disposed on the housing in contact with a portion of one of the first and second conductive members and over a part of the other conductive member;
an indicating coating on one surface of the substrate;
a conductive pattern in thermal contact with the indicating coating, the conductive pattern having a first end adjacent the first conductive member and a second end adjacent the second conductive member;
a layer of insulation covering all but the first and second ends of the conductive pattern so that pressure applied to the surface of the flexible member above the first and second ends of the conductive pattern will cause the conductive pattern to be electrically connected between the external terminals of the battery causing the conductive pattern to heat and the indicating coating to exhibit a visual change which can be related to the state of charge of the battery.

There is also provided a battery having an integral state-of-charge indicating device comprising:
a housing for containing the active components of the battery;
a first conductive portion of the housing forming a first external terminal for the battery;
a second conductive portion of the housing forming a second external terminal for the battery;
a flexible substrate on the housing covering a portion of the first and second external terminals;
a layer of electrochromic material covering a portion of the substrate;
a first electrically conductive means in electrical contact with the electrochromic material;
a second electrically conductive means in electrical contact with the electrochromic material;
a layer of electrical insulating material covering the first end and second electrically conductive means with the exception of the end portions thereof, so that pressure on the flexible substrate will cause at least one of the end portions of the first and second electrically conductive means to come into electrical contact with at least one of the first and second external terminals thereby applying a DC potential to the electrochromic material causing it to change colour or optical absorption to an extent indicative of the state of charge of the battery.

The electrochromic material preferably takes part in an oxidation/reduction reaction on application of a DC electrical potential producing a visual change in the electrochromic material.

There is also provided a combination battery and state-of-charge indicating device comprising:
a battery having first and second conductive portions forming external terminals of opposite polarity;
a state-of-charge indicating device on the battery, the device comprising:
a flexible layer forming a substrate;
a plurality of layers of thermochromic material on the substrate, the thermochromic layers exhibiting a change in colour or change in optical absorption at different temperatures;
a conductive pattern in thermal contact with the plurality of thermochromic layers, the conductive pattern having a first and a second end portion which on application of pressure to the substrate will complete an electrical circuit between the conductive pattern and the external terminals on the battery thereby causing the conductive pattern to heat and in turn cause the plurality of electrochromic layers to change colour or optical absorption in relation to the state of charge of the battery.

At least one layer of the plurality of layers of thermochromic material preferably exhibits an indicia, such as a word, indicative of the state of charge of the battery.

Thus, in one embodiment, a battery is provided with an end-of-cell voltage indicating device which can be used to indicate the state of charge of the battery. The indicating device has a flexible substrate of the same peripheral configuration as the battery. The substrate has an indicating coating on one surface which is in thermal or electrical contact with a conductive circuit pattern which can be temporarily connected between the terminals of the battery on application of pressure to an indicated spot on the surface of the substrate. The conductive circuit means causes the indicating coating to undergo a visible change which is representative of the state of charge or voltage of the battery.

In a further embodiment, the present invention provides an integral battery and state-of-charge indicating device with a battery having first and a second external terminals of opposite polarity. The state-of-charge indicating device has a flexible member on the battery covering a portion of each of the first and second external terminals. An indicating material is on one surface of the substrate. An electrical conductor is on the flexible member in association with the indicating material and is positioned for electrical contact with the first and second external terminals. Pressure on the flexible member will cause the conductor to complete an electrical circuit between the first and second external terminals on the battery causing the indicating material to change optical absorption to an extent depending on the state of charge of the battery.

An on-the-cell tester is more convenient for the user, since it is an integral part of the cell or battery and is not discarded with the original packaging. Likewise, such a tester cannot be misplaced.

The indicating material can be a thermochromic material which changes colour or becomes transparent. The colour can be used to indicate the state of the battery. If the material becomes colourless, a suitable scale underneath the material can be used to indicate the state of the battery. Many suitable thermochromic materials which change colour have been disclosed, for example, the materials of US-A-4,723,656 and those disclosed in the Parker US Patents listed above.

In addition electrochromic materials may be used, or any other suitable material which can give a visual indication of the cell's state of charge. Suitable electrochromic materials are liquid crystal materials which undergo a change in colour on application of a DC field, such as those disclosed in US-A-3,667,039. The electrochromic material can also be of the type which changes colour or optical absorption on the direct application of a DC potential which initiates a redox reaction either in the electrochromic material or in another component or in a solvent in which the electrochromic material is dissolved with the electrochromic material undergoing a change as a result of products of the oxidation and reduction of the solvent or another component. Suitable materials of this type are conventional acid base indicators such as phenolphthalein and methylene blue and also materials of the type disclosed in US-A-4,902,108.

The state-of-charge indicator can be in the form of a washer which is fastened to an end cover of the battery. The washer-like tester can be held in place by an adhesive and/or the battery wrapper which is heat shrunk onto the battery where it covers a portion of the edges of the end covers.

In another embodiment of the present invention, different layers of indicating materials are employed. The layers are activated at different temperatures or states and can be designed to change colour and/or turn clear at different temperatures. For example, the layer of material activated at the highest temperature will preferably be the bottom layer, and the upper layers are arranged in decreasing temperature of activation with the material activated at the lowest temperature in the top layer. These layers can be arranged so that, when the tester is activated, only the word "GOOD" is visible until the battery state of charge has decreased to a certain level, at which point only the word "REPLACE" becomes visible. Other suitable arrangements will be apparent to those skilled in the art.

In the manufacture of the battery voltage tester, it is preferred to use a web of the substrate material which can hold many testers, and to run the web through a suitable printing machine or coating machine where each layer of the tester can be applied at individual stations. After the several layers have been applied, the web of material can be run through a suitable punch or die cutting operation to separate the individual voltage testers from the web so that the testers can be applied to batteries in the finishing of the cell during the heat shrinking of the label.

The invention will now be further illustrated with respect to the accompanying drawings, in which:
Figure 1 is an enlarged sectional view of the battery voltage tester showing the several layers used to make the tester;
Figure 2 is a top plan view of a tester as installed on a battery with a removable proof-of-freshness seal in the centre;
Figure 3 is a plan view of a thermochromic layer used in the voltage tester;
Figure 4 is a plan view of a colour band used in the voltage tester;
Figure 5 is a plan view of a conductive pattern used in a first embodiment of the voltage tester;
Figure 6 is a plan view of a layer of insulation used on an embodiment of the voltage tester;
Figure 7A is a partial schematic view of a battery voltage tester installed on the negative end of a battery;
Figure 7B is an enlarged view of the structure included within the circle of Figure 7A;
Figure 8 is similar to Figure 2 and shows the base substrate on which the several layers of the voltage tester are supported;
Figure 9 is a plan view of spaced electrochromic coatings applied to the substrate;
Figure 10 is a plan view of an insulating layer applied over the layers of Figure 9;
Figure 11 is a plan view of the conductive pattern used in a second embodiment of the voltage tester;
Figure 12 is a plan view of a layer of insulating material on the conductive pattern of Figure 11;
Figure 13 is a plan view of a conductive pattern used in the voltage tester;
Figure 14 is a plan view of an insulation layer used on the second embodiment of the voltage tester;
Figure 15 is a schematic view of the connection between the cell being tested, the conductive pattern and the good and bad electrochromic sensors;
Figure 16 is a substrate used in a third embodiment of the present invention with indicia thereon;
Figure 17 is a word indicative of the state of the battery printed on the substrate;
Figure 18 is a layer of material used to contrast or highlight the indicative word of Figure 17;
Figure 19 is a second word indicative of the state of the battery;
Figure 20 is a layer of material of contrasting colour to highlight the graphics;
Figure 21 is a resistor/conductor layer having spaced contact portions; and
Figure 22 is a layer of electrical insulating material which covers all but the electrical contact portion of the resistor/conductor layer shown in Figure 21.

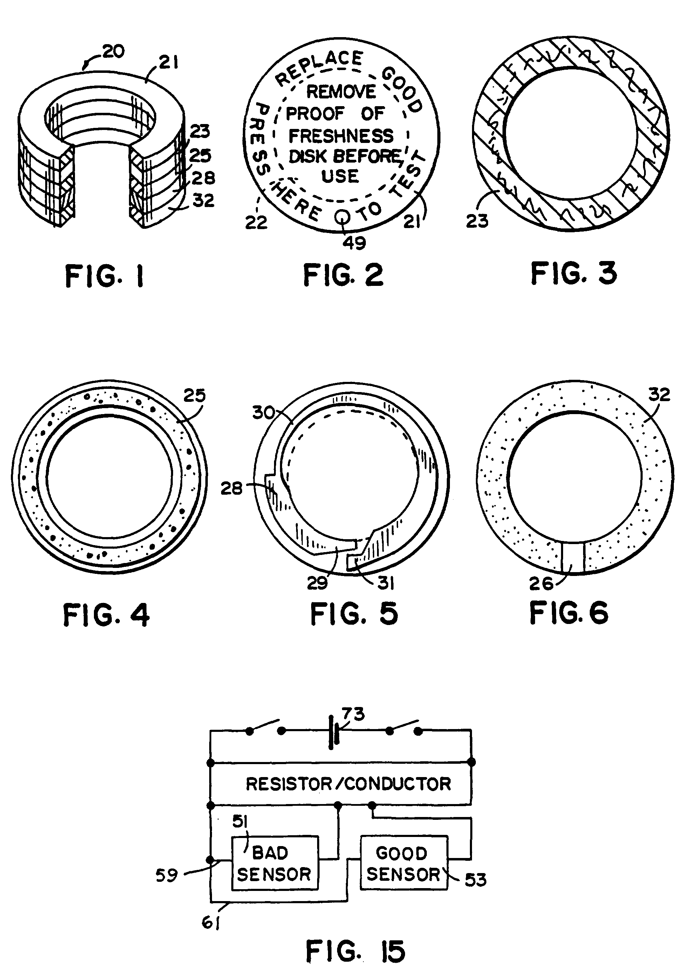

Figure 1 provides a sectional view of the voltage tester, indicated generally by the number 20, having a substrate 21 which suitably can be made from any flexible polymeric material such as polyethylene, polyester, polypropylene or polyvinyl chloride (PVC). The preferred material is polyvinyl chloride, which can be either transparent or translucent so that the change produced in the voltage tester can be viewed through the substrate. The several components making up the voltage tester are applied as layers to a surface of the substrate 21. The several layers can be applied by direct or silk screen printing techniques, for example, and built up in layers on the substrate 21.

The tester may be manufactured in a circular form on a washer sized to fit the battery to be tested and installed on the end of the cell, preferably the bottom, before the label is heat shrunk around the end of the cell. The term "bottom," as used for the cell construction described herein, refers to that end of the cell which is open during assembly and is then closed by an end cover. In the manufacture of the tester, the substrate 21 can be punched out of suitable polymeric material along with a centre portion 22 (Figure 2) which can be used as a proof of freshness seal for the battery. The peripheral edge of the centre disc 22 is partially relieved so that it can be easily removed before the battery is put into service.

The first layer of material to be applied to the substrate will depend on the type of materials used to indicate the freshness or voltage of the battery. If a thermochromic layer is to be used which becomes transparent upon heating, the layer 23 (Figure 3) can be applied to the substrate. The next layer to be applied can be the colour band 25 (Figure 4) followed by the conductive pattern indicated generally by the number 28 (Figure 5). It can be seen in Figure 5 that the conductive pattern has a pair of spaced end portions 29 and 31 and a shaped pattern 30 which progressively increases in width in a clockwise direction. The next layer applied to the voltage tester is a layer of electrical insulation 32 which covers the surface of the layer 28, with the exception of the opening at 26 through which the ends 29 and 31 are exposed. When the tester is installed on the battery, layer 32 faces the battery end cover.

A decolourising thermochromic layer 23 (Figure 3) employing a dye material, such as crystal violet lactone, may be used with a suitable phenolic material and a wax material for forming a film. A suitable decolourising combination is disclosed in US-A-4,835,476. Employing a material of this type, layer 23 can become transparent on heating and expose the layer 25 of the colour band which can be below it. The colour band may conveniently be made of any suitable printed ink pattern which is chemically compatible with the layer 23. If a thermochromic material is used which generates a colour or a visible front on heating, then the layer 25 of Figure 4 may be eliminated from the voltage tester and the layer 23 may be placed in thermal contact with the conductive pattern 28.

The conductive pattern 28 may be a silk screened layer of conductive ink incorporating copper, silver, or other conductive materials. It can also be made of any of the well-known transparent conductive materials such as a doped substoichiometric oxide of tin, indium, cadmium or zinc. As the voltage tester is only to be viewed from one side, there is no reason for the conductive pattern to be transparent. The layer 32 may be printed or silk screened over the conductive pattern using a non-conductive ink or varnish or the like, which can be used to electrically insulate all but the contact end portions of the conductive pattern 28.

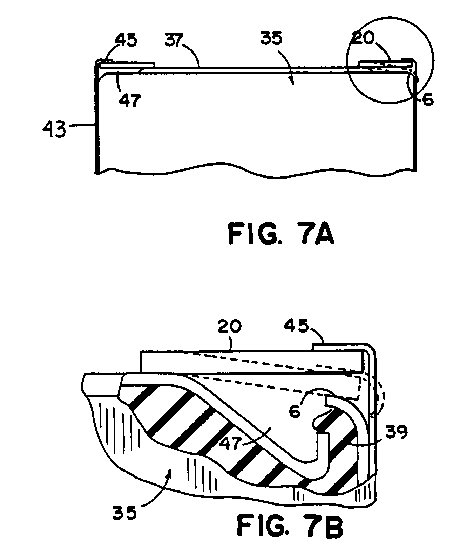

Referring now to Figure 7A, a portion of a battery, in this instance the bottom, is shown and indicated by the number 35. The negative end cover 37 is insulated from the housing or container of the battery by a suitable insulating material 39, shown in Figure 7B, leaving an air space 47 between the battery cover 37 and tester 20, discussed below. The wafer voltage tester 20 is applied to the end cover of the battery with end portion 29 of the conductive pattern 28 of Figure 5 either contacting (as shown in Figures 7A and 7B) or spaced from contact with negative end cover 37. End portion 31 is spaced from the positive portion 35 of the battery container or housing. When the tester is applied to the battery, a small amount of adhesive (not shown) may be used to hold the assembly in place. The battery label 43 is then applied over the battery with the end portion 45 of the label surrounding and gripping the peripheral edge of the voltage tester 20 to hold it in place on the end of the battery. It is advantageous in the assembly of the voltage tester and battery that the air space 47 be provided below the tester to isolate the heat generated in the conductive pattern from the thermal mass of the battery so that an accurate reading can be obtained.

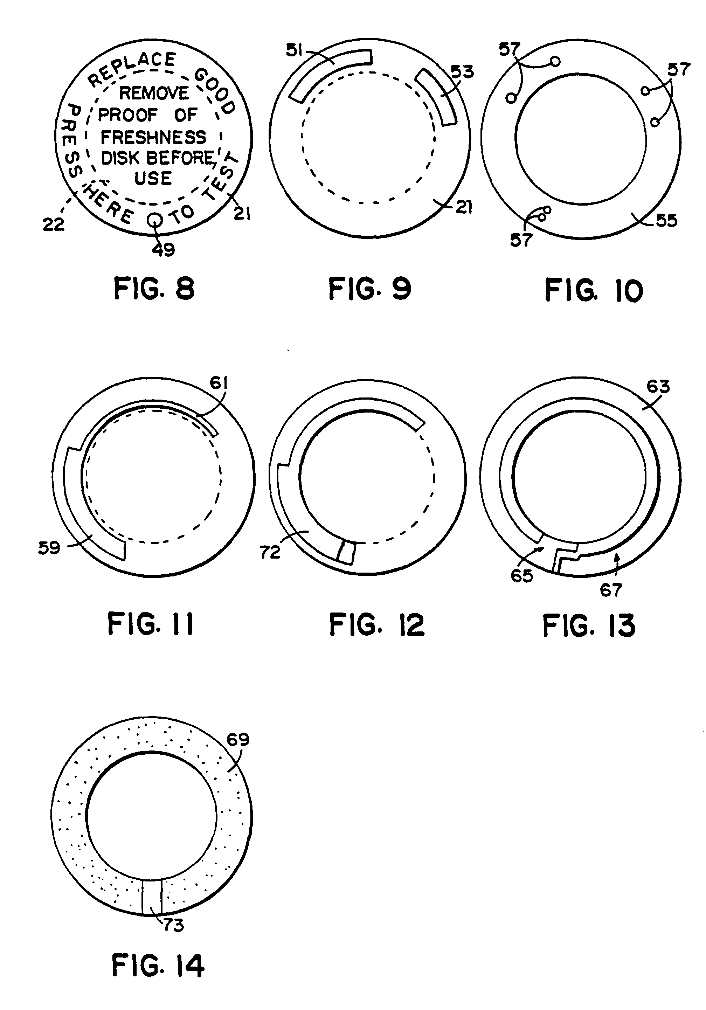

When the assembly of the voltage tester and battery is complete, referring to Figure 8, pressure applied at 49 will cause end portion 29 of conductive pattern 28 to come into electrical contact with the negative end cover of the battery while contact 31 of the same conductive pattern comes into contact with the positive portion of the battery housing, causing current to flow through the shaped portion 30. The heat generated will cause a temperature gradient from hot to cool, depending on the current, and activate the thermochromic material to reveal, in this instance, the words "REPLACE" and/or "GOOD," depending on the freshness of the battery. The extent of the temperature gradient in the thermochromic layer is dependent on the voltage of the battery. If the battery voltage is low, the DC potential may not be high enough to generate sufficient current to create a temperature gradient beyond the word "REPLACE" which indicates that the battery should be discarded.

In another embodiment of the battery tester, an electrochromic material is used which can develop a visible discontinuity, depending on the voltage or state of charge of the battery. As shown in Figure 8, the substrate is similar to that shown in Figure 2. The same type of transparent or translucent material can be used for the layer 21 with the proof of freshness disc 22 again being removable when the battery is put into service.

Similar to the first embodiment of the present invention, the electrochromic embodiment can be printed or coated in multiple layers on a plastic web substrate and then be die cut or stamped out at the end of the manufacturing process. The completed battery testers can then be used in the finishing process in the battery manufacture. For example, a web of polymeric material 21 can be fed through a multiple position printing machine where, at the first printing station, the graphics are printed in reverse. In the next printing station, two or more electrochromic layers, such as 51 and 53, which can be of the same or different electrochromic characteristics, can be applied.

The next layer of material to be applied to the voltage tester is a layer of electrical insulation 55 which has a plurality of spaced apertures 57 therein which provide access to the ends of the electrochromic deposits 51 and 53 for their respective electrical connections. Next, a conductive pattern is applied consisting of two parts 59 and 61. Conductive pattern 61 is substantially longer than conductive pattern 59 and extends in a clockwise direction around the substrate, as shown in Figure 11. A layer of electrical insulating material 72 is then applied over substantially all of conductive patterns 59 and 61 (Figure 12). As pointed out above, the conductive patterns 59 and 61 are in electrical contact with one end of each of the electrochromic layers 51 and 53.

The next layer to be applied to the voltage tester is shown in Figure 13 and is a resistor/conductor pattern 63, having a first end portion 65 and a second end portion 67. The resistor/conductor material 63 may be any type of suitable conductor material such as a metallised layer or, preferably, a conductive ink, such as an ink containing carbon black, which can be applied through printing. The end portion 65 of the resistor/conductor pattern 63 is in electrical contact with the exposed ends of conductive patterns 59 and 61. The resistor/conductor portion 63 is then covered by a layer of insulation 69 (Figure 14) except in the area 73 where the insulating pattern leaves the end portions 65 and 67 of the resistor layer 63 exposed. This completes the assembly of the electrochromic voltage tester. The testers can now be die cut or stamped from the web of polymeric material and sent to the battery finishing area where the tester 20 can be applied to the end of the battery, as shown in Figure 7.

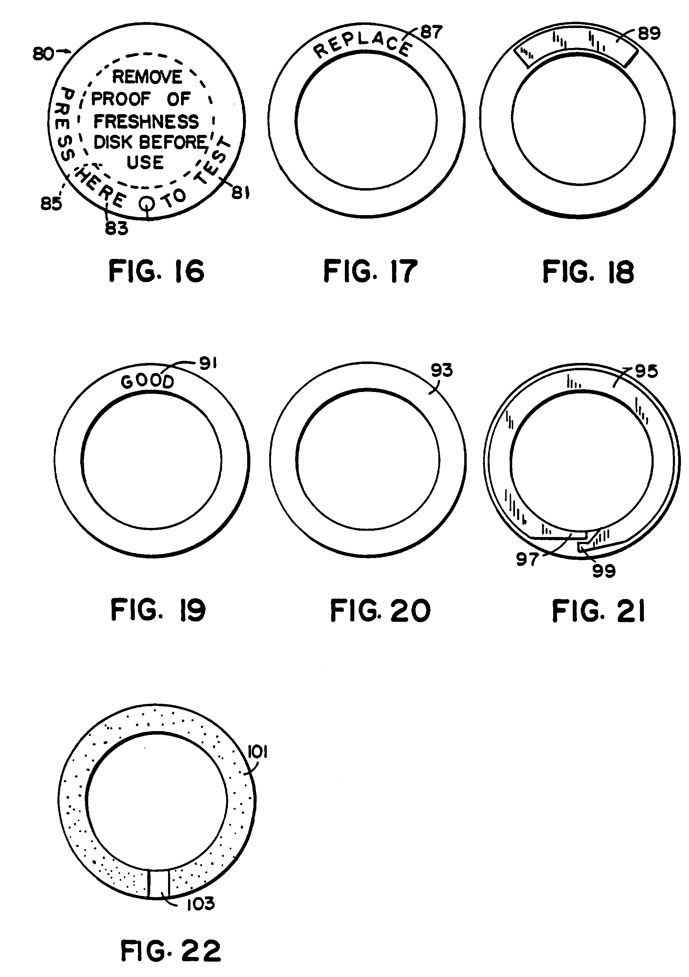

Referring to Figure 15, a simplified schematic of the voltage tester is shown connected across a cell 73. The conductive patterns 59 and 61 and the electrochromic layers 51 and 53 are electrically connected through the spaced apertures 57 in the insulation layer 55 shown in Figure 10. When the switches are closed, connecting the voltage tester to both terminals of the battery, a good battery will produce enough voltage to turn on both the good and bad sensors. A weak battery will only have enough potential to turn on the bad sensor.

In another embodiment of the battery tester, referring to Figures 16-22, two or more layers of thermochromic inks are printed on top of one another so that when one or more of the thermochromic layers are activated, the successive layers turn clear, exposing the printed message below. As shown in Figure 16, the battery tester is indicated generally by the number 80. The first stage of a multi-stage printing operation involves printing the polymeric material 81 with the graphics 83, showing where to "press to test." As in the other embodiments, a removable proof of freshness seal 85 is included.

The second stage of the printing operation involves reverse printing with thermochromic ink an indicative word 87 (Figure 17) to indicate that the battery is too weak to pass the test when the tester is energised, and should be replaced.

The third stage of the printing operation involves printing a colour band 89 with thermochromic ink (Figure 18) to contrast the indicative word.

The fourth stage of the printing operation prints the word at 91, indicating a good battery (Figure 19).

The fifth stage of the printing operation involves printing a contrasting colour 93 to highlight the graphics (Figure 20).

In the sixth stage of the printing operation, an electrically conductive pattern 95 (Figure 21) is printed. The resistor/conductor pattern 95 is similar to the resistor/conductor pattern 63 shown in Figure 13. Resistor/conductor pattern 95 has spaced contact portions 97 and 99.

In the seventh and final stage of the printing operation, an electrical insulating pattern 101 (Figure 22) is printed which prevents contact with the battery bottom cover except for the switch area of the resistor/conductor 95 where the contact portions 97 and 99 are exposed through the space 103 in electrically insulating layer 101. If the battery is good, then the resistor/conductor 95 in Figure 21 will rise to a temperature high enough to cause the thermochromic inks to turn clear, showing the message in Figure 19.

In this embodiment, a temperature gradient along the resistor/conductor is not needed and, in fact, is undesirable because the temperature reached by the resistor/conductor will cause a change in the colour of the thermochromic material to indicate directly the state of charge of the battery. A temperature gradient in this embodiment would cause only a partial colour change, thereby confusing the consumer.

A preferred voltage tester useful in this invention is continually attached to an end cover of a battery container which serves as one terminal. The tester can be applied to either the positive or the negative terminal of the battery.

In the above description of the Figures, it will be appreciated that, where a definitive statement is used, this is only with respect to the embodiments described, and is not necessarily an essential feature of the invention.

## Claims

1. An electrochemical cell and a state-of-charge tester (20) therefor, the cell comprising an open-ended container for the active ingredients of the cell and providing one terminal (35), a cover (37) providing the other terminal of the cell and being sealed over and insulated from the open end of the container, the tester (20) being resiliently deformable and configured so that at least one of the terminal contacts (29) is biassed away from contact with the relevant terminal such that manual pressure is sufficient to complete the contact thereby to complete a circuit between both terminals of the battery, the tester further comprising an electrically resistive portion between the terminal contacts (29, 31) and in cooperative contact with an element (23) visibly responsive to the condition of the resistive portion, wherein the tester (20) is located on an end of the cell, the terminal contacts (29, 31) of the tester are secured in proximity to the cover, and wherein said manual pressure is exertable at said end of the cell (49) and at the periphery of the cover.

2. A cell and tester according to claim 1, wherein the tester is adapted so that the terminal contacts make contact with the cover and the container in close proximity to the insulating seal.

3. A cell and tester according to claim 1 or 2, wherein the contacts are spaced across the seal, preferably adjacent each other across the seal, manual pressure over the two being sufficient to establish the necessary contact.

4. A cell and tester according to any preceding claim, wherein one contact is secured to its terminal.

5. A cell and tester according to any preceding claim, wherein the contacts are spaced apart and both are biassed.

6. A cell and tester according to any preceding claim, wherein the resistive portion is as long as possible, so as to provide maximum visible exposure, the resistive portion being preferably affixed to the cell.

7. A cell and tester according to any preceding claim, wherein the resistive portion is located about the periphery of the bottom, so that it may readily be observed by a user pressing the contact(s).

8. A cell and tester according to any preceding claim, wherein the responsive element comprises a thermochromic or electrochromic material close enough to the resistive element to respond to its condition.

9. A cell and tester according to any preceding claim, wherein the tester is in the form of a washer situated on the bottom of the cell, with a suitable substrate supporting the various elements of the tester, the washer preferably being held on the cell by a shrink-wrap label.

10. A cell and tester according to any preceding claim, wherein the tester comprises a detachable safety cover to prevent inadvertant electrical contact with the bottom of the cell prior to use.

11. A cell or tester according to any preceding claim, wherein the responsive element comprises at least two different materials each responding to a different state of the resistive element, such as different temperatures.

## Patentansprüche

1. Elektrochemische Zelle und Prüfgerät für den Spannungszustand (20) derselben, wobei die Zelle einen Behälter mit einem offenen Ende für die aktiven Bestandteile der Zelle aufweist und mit einem Anschluß (35) versehen ist, während ein Deckel (37) mit dem anderen Anschluß der Zelle versehen ist und im abgedichteten und isolierten Zustand über dem offenen Ende des Behälters angeordnet ist, wobei das Prüfgerät (20) elastisch verformbar ist und so ausgebildet ist, daß wenigstens einer der Anschlußkontakte (29) weg von dem Kontakt mit dem entsprechenden Anschluß ausgerichtet ist, so daß ein manueller Druck ausreicht, um den Kontakt herzustellen und so den Stromkreis zwischen den beiden Anschlüssen der Batterie zu schließen, wobei das Prüfgerät desweiteren einen elektrischen Widerstandsteil zwischen den Anschlußkontakten (29, 31) aufweist und in einem zusammenwirkenden Kontakt mit einem Element (23) steht welches sichtbar auf den Zustand des Widerstandsteiles anspricht, Zelle und Prüfgerät bei welchen das Prüfgerät (20) an einem Ende der Zelle angeordnet ist, die Anschlußkontakte (29; 31) des Prüfgerätes in der Nähe des Deckels angebracht sind, und bei welchen der besagte manuelle Druck an dem besagten Ende der Zelle (49) und an dem Umfang des Deckels ausgeübt werden kann.

2. Zelle und Prüfgerät gemäß Anspruch 1, bei welchen das Prüfgerät so ausgelegt ist, daß die Anschlußkontakte einen Kontakt mit dem Deckel und dem Behälter in knapper Entfernung zu der isolierenden Dichtung herstellen.

3. Zelle und Prüfgerät gemäß Anspruch 1 oder 2, bei welchen die Kontakte über die Dichtung voneinander entfernt angeordnet sind, vorzugsweise der eine über die Dichtung hinweg angrenzend an den anderen Kontakt, wobei ein manueller Druck auf die beiden ausreicht, um den notwendigen Kontakt herzustellen.

4. Zelle und Prüfgerät gemäß irgendeinem der vorhergehenden Ansprüche, bei welchen ein Kontakt an seinem Anschlußpunkt befestigt ist.

5. Zelle und Prüfgerät gemäß irgendeinem der vorhergehenden Ansprüche, bei welchen die Kontakte einer von dem anderen entfernt sind und beide auseinandergehend ausgerichtet sind.

6. Zelle und Prüfgerät gemäß irgendeinem der vorhergehenden Ansprüche, bei welchen der Widerstandsteil so lang wie möglich ist, so daß für eine Ausstellungslage mit maximaler Sichtbarkeit gesorgt ist, wobei der Widerstandsteil vorzugsweise an der Zelle befestigt ist.

7. Zelle und Prüfgerät gemäß irgendeinem der vorhergehenden Ansprüche, bei welchen der Widerstandsteil um den Umfang des Bodens herum angeordnet ist, so daß er von einem Benutzer, welcher den (die) Kontakt(e) drückt, leicht beobachtet werden kann.

8. Zelle und Prüfgerät gemäß irgendeinem der vorhergehenden Ansprüche, bei welchen das ansprechende Element ein thermochromisches oder ein elektrochromisches Material aufweist, welches nahe genug bei dem Widerstandselement liegt, um auf seinen Zustand anzusprechen.

9. Zelle und Prüfgerät gemäß irgendeinem der vorhergehenden Ansprüche, bei welchen das Prüfgerät in der Form einer Zwischenscheibe vorliegt, welche auf dem Boden der Zelle angeordnet ist, wobei eine geeignete Unterlage die verschiedenen Elemente des Prüfgerätes trägt, während die Zwischenscheibe vorzugsweise durch ein Etikett in der Form einer Schrumpfhülle auf der Zelle festgehalten wird.

10. Zelle und Prüfgerät gemäß irgendeinem der vorhergehenden Ansprüche, bei welchen das Prüfgerät einen abnehmbaren Sicherheitsdeckel umfaßt, um einen durch eine Unachtsamkeit verursachten elektrischen Kontakt mit dem Boden der Zelle vor dessen Einsatz zu verhindern.

11. Zelle und Prüfgerät gemäß irgendeinem der vorhergehenden Ansprüche, bei welchen das ansprechende Element wenigstens zwei verschiedene Materialien aufweist, von denen ein jedes auf einen unterschiedlichen Zustand des ansprechenden Elementes reagiert, so wie etwa auf verschiedene Temperaturen.

## Revendications

1. Cellule électrochimique et testeur de niveau de charge (20) pour celle-ci, la cellule comprenant un conteneur à extrémité ouverte pour contenir les ingrédients actifs de la cellule et comportant une des bornes (35), un couvercle (37) comportant l'autre borne de la cellule et étant monté de façon étanche sur l'extrémité ouverte du conteneur tout en étant isolé de celui-ci, le testeur (20) étant déformable de façon élastique et étant configuré de telle sorte qu'au moins l'un des contacts de bornes (29) est soumis à une poussée qui l'éloigne du contact avec la borne en question, de telle sorte qu'une pression manuelle est suffisante pour établir le contact, ce qui ferme le circuit entre les deux bornes de la batterie, le testeur comprenant en outre une partie électriquement résistive située entre les contacts de bornes (29, 31) et en venant en contact concourant avec un élément (23) qui est de façon visible sensible à l'état de la partie résistive; cellule dans laquelle le testeur (20) est situé à une extrémité de la cellule, les contacts de bornes (29, 31) du testeur sont fixés à proximité du couvercle, et pour laquelle ladite pression manuelle peut être exercée à ladite extrémité de la cellule (49) et à la périphérie du couvercle.

2. Cellule et testeur selon la revendication 1, dans lesquels le testeur est façonné de telle manière que les contacts de bornes entrent en contact avec le couvercle et le conteneur à proximité immédiate du joint d'étanchéité isolant.

3. Cellule et testeur selon la revendication 1 ou 2, dans lesquels les contacts sont tenus espacés par l'intermédiaire du joint d'étanchéité alors qu'ils sont de préférence adjacents l'un par rapport à l'autre à travers le joint d'étanchéité, une pression manuelle par-dessus les deux contacts étant suffisante pour établir le contact nécessaire.

4. Cellule et testeur selon l'une quelconque des revendications précédentes, dans lesquels un contact est fixé sur sa borne.

5. Cellule et testeur selon l'une quelconque des revendications précédentes, dans lesquels les contacts sont espacés l'un de l'autre et tous les deux sont soumis à une poussée.

6. Cellule et testeur selon l'une quelconque des revendications précédentes, dans lesquels la partie résistive est aussi longue que possible, afin de constituer une zone d'exposition à visibilité maximale, la partie résistive étant de préférence fixée à la cellule.

7. Cellule et testeur selon l'une quelconque des revendications précédentes, dans lesquels la partie résistive est située autour de la périphérie du fond, de telle sorte qu'elle puisse être facilement observée par un utilisateur qui presse le ou les contact(s).

8. Cellule et testeur selon l'une quelconque des revendications précédentes, dans lesquels l'élément sensible comprend un matériau thermochromique ou électrochromique qui est suffisamment rapproché de l'élément résistif pour être sensible à son état.

9. Cellule et testeur selon l'une quelconque des revendications précédentes, dans lesquels le testeur possède la forme d'une rondelle située sur le fond de la cellule, un substrat approprié supportant les divers éléments du testeur, la rondelle étant de préférence maintenue sur la cellule à l'aide d'une étiquette à effet d'enveloppement par rétraction.

10. Cellule et testeur selon l'une quelconque des revendications précédentes, dans lesquels le testeur comprend un couvercle de sécurité détachable destiné à éviter la mise en contact électrique par inadvertance avec le fond de la cellule avant son utilisation.

11. Cellule et testeur selon l'une quelconque des revendications précédentes, dans lesquels l'élément sensible comprend au moins deux matériaux différents dont chacun est sensible à un état différent de l'élément résistif, tel que des températures différentes.
